# EUROPÄISCHE PATENTSCHRIFT

(11) **EP 1 045 627 B1**
(45) Veröffentlichungstag und Bekanntmachung des Hinweises auf die Patenterteilung: **05.09.2007**
(21) Anmeldenummer: 00107531.6
(22) Anmeldetag: 07.04.2000
(51) Int. Cl.: H05K 3/10

(54) **Herstellen von Leiterbahnen auf Kunststoffen durch Laserenergie**
Method for making conductor tracks with a laser on plastics materials
Procédé de fabrication de pistes conductrices sur des matières plastiques au moyen d'un laser

(30) Priorität: 12.04.1999 DE 19916467
(43) Veröffentlichungstag der Anmeldung: 18.10.2000
(73) Patentinhaber: Ticona GmbH, 65451 Kelsterbach (DE)
(72) Erfinder: Reil, Frank, Dipl.-Ing., 64342 Seeheim (DE); Pieper, Volker, 55130 Mainz (DE); Tönnes, Kai-Uwe, Dr., 55278 Köngernheim (DE)

(56) Entgegenhaltungen:
- EP-A- 0 340 997
- EP-A- 0 476 320
- US-A- 4 608 129

## Beschreibung

Die vorliegende Erfindung betrifft ein Verfahren zur Bildung von elektrisch leitenden Schichten, insbesondere Leiterbahnen an der Oberfläche von Kunststoffen durch Bestrahlung mit Laserenergie.

Formteile aus Kunststoff mit integrierten elektrisch leitenden Schichten oder Bahnen sind beispielsweise aus der Elektro- und Elektronikindustrie hinlänglich bekannt.

Um jedoch Leiterbahnen auf Kunststoffe zu bringen, werden bisher in aufwendigen Prozessen metallisierbare Kunststoffe in mehrstufigen Verfahren so angeordnet, daß durch partielles Metallisieren (Galvanisieren) Leiterbahnen entstehen. Eine andere Möglichkeit besteht darin, Leiterbahnen durch Heißprägen auf die Kunststoffoberfläche zu bringen.

Die bisher bekannten Verfahren zur Herstellung von Formteilen aus Kunststoff mit integrierten Leiterbahnen sind sehr kostenintensiv und zum Teil wenig umweltfreundlich, so daß alternative Möglichkeiten gesucht werden. Die Bestrahlung von gefüllten Formmassen mit Laserenergie stellt eine solche alternative Möglichkeit dar.

Die Markierung von mit leitfähigen Bestandteilen gefüllten Kunststoffen wird in DE-OS 44 15 802 beschrieben. Bei der beschriebenen Verwendung von dotiertem Zinndioxid, Glimmerplättchen oder Siliziumdioxid-Flakes können zwar Markierungen, jedoch keine Leiterbahnen durch Bestrahlen mit Laserenergie erzeugt werden.
In US 4,841,099 wird die Herstellung von elektrischen Leiterbahnen in einem mit nichtleitenden Fasern gefüllten Kunststoff beschrieben. Diese Fasern, vorzugsweise Polyacrylnitrilfasern, werden bei Bestrahlung mit entsprechender Laserenergie in leitende Kohlenstoffasern umgewandelt. Von Nachteil sind hier jedoch die geringere Leitfähigkeit von Kohlenstoff gegenüber Metallen und die mit der Verwendung von Kunststoffasern als Füllmittel in einem anderen Kunststoff verbundenen Einschränkungen.
In EP-OS 0 230 128 wird die Herstellung von Leiterbahnen durch Bestrahlung mit entsprechender Laserenergie auf pyrolysierbaren Substraten beschrieben. Hierbei entstehen leitende Kohlenstoffspuren, die optional durch Elektrolyse mit einer geeigneten Metallschicht überzogen werden können. Von Nachteil ist jedoch die Beschränkung auf geeignete Kunststoffe und die geringere Leitfähigkeit des Kohlenstoffs, wodurch die nachfolgende Beschichtung der Leiterbahn mit Metall notwendig wird.

Aufgabe der vorliegenden Erfindung war die Herstellung von Leiterbahnen nahe der Oberfläche eines elektrisch weitgehend isolierenden Kunststoffes.

Diese Aufgabe wird gelöst durch Bestrahlung eines mit elektrisch leitfähigen Bestandteilen gefüllten, jedoch selbst elektrisch weitgehend isolierenden Kunststoffes mit entsprechender Laserenergie.

Bei diesem Verfahren wird die Oberfläche eines Kunststoffs, der mit elektrisch leitfähigen Bestandteilen gefüllt ist, mit Laserenergie bestrahlt. Durch die Bestrahlung wird der Kunststoff an der Einstrahlstelle bis zu einer vorbestimmten Tiefe partiell verdampft, wobei die elektrisch leitenden Bestandteile zurückbleiben und sich zu einer elektrisch leitenden Schicht oder Bahn vereinigen.
Es erfolgt eine Verschmelzung der zurückbleibenden elektrisch leitenden Bestandteile mit der neu gebildeten Kunststoffoberfläche durch wiederholte Bestrahlung mit Laserenergie an der Einstrahlstelle.

Die Erfindung betrifft daher ein Verfahren zur Herstellung von elektrisch leitenden Schichten an der Oberfläche von Kunststoffen umfassend die Bestrahlung der Oberfläche eines Kunststoffes enthaltend elektrisch leitfähige Bestandteile, ausgewählt aus der Gruppe der Metalle, der Metalllegierungen, der Ruße und Graphite, mit Laserenergie, so daß an der Einstrahlstelle der Kunststoff bis zu einer vorbestimmten Tiefe durch die Laserenergie partiell verdampft wird, wobei die elektrisch leitfähigen Bestandteile zurückbleiben und sich anreichern und somit eine elektrisch leitende Schicht bilden; und die Verschmelzung der elektrisch leitenden Bestandteile durch die Bestrahlung mit Laserenergie an der Einstrahlstelle erfolgt; und die Verschmelzung der zurückbleibenden elektrisch leitfähigen Bestandteile durch eine wiederholte Bestrahlung mit Laserenergie an der Einstrahlstelle mit der neu gebildeten Kunststoffoberfläche erfolgt.

Die Erfindung betrifft auch Formteile aus Kunststoff mit integrierten elektrisch leitenden Schichten oder Bahnen an seiner Oberfläche erhältlich durch Bestrahlen eines Kunststoffes, enthaltend elektrisch leitfähige Bestandteile, ausgewählt aus der Gruppe der Metalle, der Metalllegierungen, der Ruße und Graphite, mit Laserenergie wobei an der Einstrahlstelle der Kunststoff bis zu einer vorbestimmten Tiefe durch die Laserenergie partiell verdampft wird, die elektrisch leitfähigen Bestandteile zurückbleiben und sich anreichern und somit eine elektrisch leitende Schicht oder Bahn bilden, wobei die elektrisch leitfähigen Bestandteile in der elektrisch leitenden Schicht oder Bahn durch wiederholtes Bestrahlen mit der neu gebildeten Kunststoffoberfläche verschmolzen werden.

Derartige Formteile können beispielsweise in der Elektro- und Elektronikindustrie verwendete Bauteile sein, aber auch andere beliebig geformte große oder kleine Kunststoffteile, die an bestimmten Stellen mit leitenden Elementen versehen sind. Das erfindungsgemäße Formteil kann auch Bestandteil eines Verbundkörpers mit anderen Materialien sein.

Da der Kunststoff, der mit elektrisch leitfähigen Bestandteilen gefüllt ist, sich in seinen chemischen und insbesondere mechanischen Eigenschaften vom gleichen Kunststoff ohne diese Bestandteile unterscheiden und auch etwas teurer sein kann, kann es insbesondere bei größeren Formteilen angebracht sein, den Grundkörper des Formteils und bestimmten Elemente, an denen leitende Schichten oder Bahnen gewünscht werden, aus verschiedenen Formmassen im Verbund herzustellen.

Bezüglich des erfindungsgemäß zu verwendenden Kunststoffs ist keine besondere Einschränkung erforderlich. Für das erfindungsgemäße Verfahren können prinzipiell alle organischen Kunststoffe eingesetzt werden, in die sich die elektrisch leitfähigen Bestandteile in ausreichenden Mengen einarbeiten lassen. Diese Kunststoffe können auch die üblichen Hilfs-, Zusatz-, Füll- und Verstärkungsmittel enthalten. Auch homogene und heterogene Kunststoffmischungen können verwendet werden.

Je nach Art des verwendeten Kunststoffs sind die Wellenlänge und die Intensität des eingestrahlten Laserlichts abzustimmen. Hiervon hängt insbesondere die erforderliche Einstrahldauer und somit die erreichbare Bearbeitungsgeschwindigkeit ab. Transparente Kunststoffe und solche ohne einen nennenswerten Anteil absorbierender Bestandteile ermöglichen eine höhere Einstrahltiefe. Kunststoffe mit einem größeren Anteil von Bestandteilen, die die Energie des Laserlichts absorbieren, führen zu einer stärkeren Erhitzung der Kunststoffoberfläche an der Einstrahlstelle. Hierdurch kann beispielsweise das Verdampfen des Kunststoffmaterials beschleunigt oder das Verschmelzen der elektrisch leitfähigen Bestandteile miteinander gefördert werden.

Materialien, die erfindungsgemäß als elektrisch leitfähige Bestandteile Verwendung finden, sind im allgemeinen metallischer Natur oder zählen zu den Rußen und Graphiten. Bevorzugte Metalle sind beispielsweise Zinn, Silber und Kupfer, die einzeln, als Legierung sowie in Kombination mit anderen elektrisch leitfähigen Materialien eingesetzt werden können. Die metallischen Bestandteile können in beliebiger Partikelform vorliegen, beispielsweise als Pulver, sphärisch oder faserförmig. Zu erwähnen sind hier insbesondere auch Stahlfasern, die häufig als Verstärkungsmittel eingesetzt werden.

Leitfähige Ruße und Graphite sind hinlänglich bekannt und können für sich, in Kombination miteinander oder zusammen mit anderen leitfähigen Materialien verwendet werden.

Der Anteil elektrisch leitfähiger Bestandteile in der Matrix des erfindungsgemäß zu verwendenden Kunststoffs ist im allgemeinen so zu wählen, daß der Kunststoff für sich noch isolierende Eigenschaften aufweist. Erst durch die Bestrahlung der Oberfläche und das damit verbundene partielle Verdampfen der Kunststoffmatrix wird dort der Anteil an elektrisch leitfähigen Bestandteilen zu einer leitenden Konzentration angereichert. Die erreichbare Leitfähigkeit hängt dabei von der Art und Konzentration der elektrisch leitfähigen Materialien sowie von der Dicke der gebildeten leitfähigen Schicht oder Bahn ab.

Idealerweise werden die elektrisch leitfähigen Bestandteile durch die Laserenergie miteinander verschmolzen, so daß eine durchgehende elektrisch leitende Bahn entsteht. Dieses Verschmelzen kann auch in einem nachgeschalteten Verfahrensschritt durch erneute Bestrahlung erfolgen. Es ist auch möglich, durch erneute Bestrahlung die elektrisch leitende Schicht mit der Kunststoffmatrix zu verschmelzen. In beiden Fällen kann die Energie des Laserlichts auf die zu erzielende Wirkung hin optimiert werden.

Das nachfolgend dargestellte Ausführungsbeispiel soll dem Fachmann die Erfindung und die damit erreichten Vorteile noch deutlicher darstellen.

### Beispiel 1

In die Kunststoffmatrix eines handelsüblichen Polybutylenterephthalats wurden 5 Volumen-% elektrisch leitende Partikel auf der Basis von Zinn, Silber oder Kupfer durch Extrudieren eingearbeitet. Der erhaltene Kunststoff wirkte als Isolator.

Aus dem erhaltenen Kunststoff wurde im Spritzgußverfahren ein Formteil hergestellt. Auf diesem wurde mit einem NdYAG-Laser eine linienförmige Partie bestrahlt. Durch die Laserenergie wurde das Polymer verdampft, die elektrisch leitfähigen Partikel sammelten sich an der Oberfläche der Linie an. Gleich anschließend wurde diese Linie nochmals mit Laserenergie beaufschlagt.

An den Endpunkten der Linie wurden Kontakte in die Kunststoffoberfläche eingestanzt. Mittels eines AmpereNoltmeters wurde die Leitfähigkeit der erhaltenen Leiterbahn bestätigt.

## Patentansprüche

1. Verfahren zur Herstellung von elektrisch leitenden Schichten an der Oberfläche von Kunststoffen umfassend
(a) die Bestrahlung der Oberfläche eines Kunststoffes enthaltend elektrisch leitfähige Bestandteile, ausgewählt aus der Gruppe der Metalle, der Metalllegierungen, der Ruße und Graphite, mit Laserenergie, so daß an der Einstrahlstelle der Kunststoff bis zu einer vorbestimmten Tiefe durch die Laserenergie partiell verdampft wird, wobei die elektrisch leitfähigen Bestandteile zurückbleiben und sich anreichern und somit eine elektrisch leitende Schicht bilden und
(b) die Verschmelzung der elektrisch leitenden Bestandteile durch die Bestrahlung mit Laserenergie an der Einstrahlstelle erfolgt und
(c) die Verschmelzung der zurückbleibenden elektrisch leitfähigen Bestandteile durch eine wiederholte Bestrahlung mit Laserenergie an der Einstrahlstelle mit der neu gebildeten Kunststoffoberfläche erfolgt.

2. Verfahren nach Anspruch 1, **dadurch gekennzeichnet, daß** die dreidimensionale Oberfläche eines Kunststoffs derart mit der Laserenergie bestrahlt wird, daß an der Kunststoffoberfläche elektrisch leitende Bahnen gleichmäßiger Dicke gebildet werden.

3. Formteil aus Kunststoff mit integrierten elektrisch leitenden Schichten oder Bahnen an seiner Oberfläche erhältlich durch Bestrahlen eines Kunststoffs enthaltenden elektrisch leitfähige Bestandteile, ausgewählt aus der Gruppe der Metalle, der Metalllegierungen, der Ruße und Graphite, mit Laserenergie wobei an der Einstrahlstelle der Kunststoff bis zu einer vorbestimmten Tiefe durch die Laserenergie partiell verdampft wird, die elektrisch leitfähigen Bestandteile zurückbleiben und sich anreichern und somit eine elektrisch leitende Schicht oder Bahn bilden, wobei die elektrisch leitfähigen Bestandteile in der elektrisch leitenden Schicht oder Bahn und die elektrisch leitfähigen Bestandteile in der elektrisch leitenden Schicht oder Bahn durch wiederholtes Bestrahlen mit der neu gebildeten Kunststoffoberfläche verschmolzen sind.

## Claims

1. Process for the production of electrically conductive layers on the surface of plastics, comprising
(a) the irradiation of the surface of a plastic containing electrically conductive constituents selected from the group of metals, metal alloys, carbon blacks and graphites with laser energy in such a way that the plastic is partially evaporated down to a predetermined depth at the point of incidence by the laser energy, leaving behind the electrically conductive constituents, which increase in concentration and thus form an electrically conductive layer, and
(b) the intermelting of the electrically conductive constituents at the point of incidence by the irradiation with laser energy, and
(c) the intermelting of the electrically conductive constituents which are left behind with the newly formed plastic surface by repeated irradiation with laser energy at the point of incidence.

2. Process according to Claim 1, **characterized in that** the three-dimensional surface of a plastic is irradiated with the laser energy in such a way that electrically conductive tracks of uniform thickness are formed on the plastic surface.

3. Plastic molding with integrated electrically conductive layers or tracks on its surface, obtainable by irradiation of a plastic containing electrically conductive constituents selected from the group of metals, metal alloys, carbon blacks and graphites with laser energy, where the plastic is partially evaporated down to a predetermined depth at the point of incidence by the laser energy, leaving behind the electrically conductive constituents, which increase in concentration and thus form an electrically conductive layer or track, wherein the electrically conductive constituents in the electrically conductive layer or track and the electrically conductive constituents in the electrically conductive layer or track have become intermelted with the newly formed plastic surface through repeated irradiation.

## Revendications

1. Procédé de fabrication de couches électriquement conductrices à la surface de matières synthétiques, lequel procédé comprend les étapes qui consistent à :
(a) irradier avec une énergie laser la surface d'une matière synthétique qui contient des composants électriquement conducteurs sélectionnés dans l'ensemble constitué des métaux, des alliages de métaux, du noir de carbone et des graphites de telle sorte qu'à l'emplacement irradié, la matière synthétique soit en partie évaporée par l'énergie laser jusqu'à une profondeur prédéterminée, les composants électriquement conducteurs restant et se concentrant pour ainsi former une couche électriquement conductrice,
(b) faire fondre les composants électriquement conducteurs en irradiant avec de l'énergie laser l'emplacement d'irradiation et
(c) faire fondre les composants électriquement conducteurs résiduels avec la surface en matière synthétique nouvellement formée, en irradiant de nouveau avec de l'énergie laser l'emplacement d'irradiation.

2. Procédé selon la revendication 1, **caractérisé en ce que** la surface tridimensionnelle d'une matière synthétique est irradiée par de l'énergie laser de telle sorte que des pistes électriquement conductrices d'épaisseur constante se forment à la surface de la matière synthétique.

3. Pièce moulée en matière synthétique à la surface de laquelle des couches ou des pistes électriquement conductrices sont intégrées, obtenue par irradiation avec une énergie laser d'une matière synthétique qui contient des composants électriquement conducteurs sélectionnés dans l'ensemble constitué des métaux, des alliages de métaux, du noir de carbone et des graphites de telle sorte qu'à l'emplacement irradié, la matière synthétique soit en partie évaporée par l'énergie laser jusqu'à une profondeur prédéterminée, les composants électriquement conducteurs restant et se concentrant pour ainsi former une couche ou une piste électriquement conductrice et les composants électriquement conducteurs de la couche ou de la piste électriquement conductrice et les composants électriquement conducteurs de la couche au de la piste électriquement conductrice étant fondus avec la surface en matière synthétique nouvellement formée en les irradiant de nouveau.
